Europäisches Patentamt

European Patent Office

Office européen des brevets

(19)

(11) Numéro de publication: **0 033 703**
**B1**

(12) **FASCICULE DE BREVET EUROPEEN**

(45) Date de publication du fascicule du brevet: **28.09.83**

(51) Int. Cl.³: **G 01 N 24/06**

(21) Numéro de dépôt: **81400158.2**

(22) Date de dépôt: **03.02.81**

(54) **Aimant sans circuit magnétique, à haute homogénéité, notamment pour imagerie par résonance magnétique nucléaire.**

(30) Priorité: **05.02.80 FR 8002496**

(43) Date de publication de la demande:
**12.08.81 Bulletin 81/32**

(45) Mention de la délivrance du brevet:
**28.09.83 Bulletin 83/39**

(84) Etats contractants désignés:
**DE FR GB NL**

(56) Documents cités:
**FR - A - 1 185 479**
**US - A - 3 564 398**
**US - A - 3 622 869**

(73) Titulaire: **THOMSON-CSF**
**173, Boulevard Haussmann**
**F-75379 Paris Cedex 08 (FR)**

(73) Titulaire: **ANVAR Agence Nationale de**
**Valorisation de la Recherche**
**13, rue Madeleine Michelis**
**F-92522 Neuilly-sur-Seine (FR)**

(72) Inventeur: **Barjhoux, Yves**
**THOMSON-CSF SCPI 173, bld Haussmann**
**F-75360 Paris Cedex 08 (FR)**
Inventeur: **Saint Jalmes, Hervé**
**THOMSON-CSF SCPI 173, bld Haussmann**
**F-75360 Paris Cedex 08 (FR)**
Inventeur: **Taquin, Jacques**
**THOMSON-CSF SCPI 173, bld Haussmann**
**F-75360 Paris Cedex 08 (FR)**

(74) Mandataire: **Barbin le Bourhis, Joel et al,**
**THOMSON-CSF SCPI 173, boulevard Haussmann**
**F-75379 Paris Cedex 08 (FR)**

Courier Press, Leamington Spa, England.

# Aimant sans circuit magnétique, à haute homogénéité, notamment pour imagerie par résonance magnétique nucléaire

La présente invention concerne un aimant sans circuit magnétique, à haute homogénéité, à double accès. Elle est particulièrement adaptée à l'imagerie par résonnance Magnétique Nucléaire.

Un exploitation possible du phénomène de la RMN est l'application à l'imagerie.

L'application du phénomène de la RMN au corps humain entier, et ses prolongements, se développe dans le domaine médical en raison d'un certain nombre d'avantages fondamentaux. Tout d'abord l'examen RMN est inoffensif pour les tissus vivants contrairement aux rayons X. Il est ensuite possible de fournir des données de concentration nucléaire analogues aux données de faisceau pour la reconstruction d'image du procédé tomodensitométrique. Un autre avantage à souligner réside dans le possibilités de la RMN en analyse biochimique qui permettra par exemple la détection in vivo de tumeurs cancéreuses.

L'art antérieur comporte des solutions au problème de l'imagerie par RMN. Mais les temps de pose pour chaque pose sont prohibitifs, de l'ordre de une heure. Ce fait est causé par la très faible sensibilité du phénomène RMN. En effet, le signal de RMN est noyé dans un bruit thermique très important. Une solution possible que l'on va maintenant développer concerne l'augmentation de l'homogénéité du champ magnétique orientateur $\vec{B}_o$. Ce champ magnétique doit orienter les moments magnétique nucléaires des particules élémentaires qui composent le corps examiné et plus particulièrement des protons. Il doit donc être relativement constant en intensité et direction dans tout le domaine d'examen.

Quand le défaut d'homogénéité du champ $\vec{B}_o$, est suffisamment réduit, il est possible d'appliquer des gradients de champ, destinés à la reconstruction de l'image, d'une intensité plus faible ce qui permet de réduire le bruit thermique. De plus, la disparition de nombreux défauts dans l'homogénéité réduira les distorsions spatiales de l'image.

Une telle amélioration de la technique d'imagerie RMN permet d'envisager son application en contrôle non destructif des matériaux. Par exemple, il sera possible de détecter des défauts de fabrication dans une pièce en matière plastique. On peut ainsi envisage des contrôles de processus évolutifs sans perturbation par sonde, par exemple dans des débits fluides.

Les solutions de l'art antérieur se sont donc attachées à créer un champ magnétique $\vec{B}_o$, le plus homogène possible, sur un volume comparable à celui du corps humain. Mais la réalisation d'un aimant convenable passe par l'optimisation de trois grandeurs caractéristiques de l'aimant:

— le défaut d'homogénéité $B_d$ du champ $\vec{B}_o$;
— la consommation d'énergie électrique, de fluide de refroidissement et l'encombrement de l'aimant;
— le volume d'examen et son accessibilité.

Les aimants proposés par l'état de la technique pour obtenir un défaut d'homogénéité réduit et une accessibilité au volume d'examen amélioré, sont des ensembles encombrants et consommateurs. Il est alors nécéssaire d'employer des techniques de mise en oeuvre de la RMN assez peu sensibles, par exemple la technique de bobine de RMN en "selle de cheval".

En se donnant une accessibilité selon deux directions et un volume utile d'examen amélioré, la présente invention permet d'améliorer l'homogénéité du champ et de réduire consommation et encombrement. L'invention vise un catégore particulière de tels aimants uniquement constitués de bobines électromagnétiques de révolution. Le brevet US—A—3 564 398 divulgue un tel agencement à accès longitudinal. L'invention concerne un aimant sans circuit magnétique, à haute homogénéité, et comportant un volume d'examen pour exposer un corps à un champ magnétique orientateur, constitué d'un agencement de bobines électromagnétiques de révolution, coaxiales ayant de telles bobines disposées symétriquement par paires de part et d'autre d'un plan de symétrie perpendiculaire à leur axe commun, chaque bobine étant définie par ses paramètres caractéristiques:

— courant d'excitation NI,
— rayon moyen R
— distance d audit plan de symétrie

caractérisé en ce que ledit aimant est constitué exclusivement d'au moins trois paires desdites bobines disposées symétriquement par paires de part de d'autre dudit plan de symétrie, ledit volume d'examen, à accès transversal par rapport à l'axe commun étant situé de part et d'autre dudit plan de symétrie et étant délimité par les deux faces opposées des bobines de la paire la plus proche dudit plan de symétrie. L'invention est maintenant décrite à l'aide d'un exemple de réalisation illustré par les figures qui sont:

— la figure 1: un schéma de configuration à trois paires de bobines;
— la figure 2: un stéréogramme représentant la composante $B_z$ du champ magnétique dans le volume d'examen.

L'art antérieur a amené des solutions à deux paires de bobines. En effet le champ le plus homogène réalisable est créé par une sphère parcourue par un courant. L'art antérieur a donc produit des réalisations où les bobines sont circulaires et plates, réparties sur une sphère, leur axe de révolution passant par le centre de la sphère, et symétriques deux à deux par rapport à un plan diamétral de la sphère passant par le centre de la sphère et perpendiculaire à l'axe de révolution.

On peut montrer que la composante selon oz du champ au voisinage de l'origine d'un tel système est de la forme:

$$B_z(z) = B_0 + B_2\frac{z^2}{2!} + B_4\frac{z^4}{4!} + B_6\frac{z^6}{6!} + \ldots$$

qui est un développement en série de Taylor. Les termes $B_k$ sont les nombre dérivées partiels par rapport à Oz, axe de révolution, du champ $B_o$. Les termes d'ordre impair sont nuls à cause de la symétrie par rapport au plan 4 de l'aimant. Les termes d'ordre pair représentent les défauts d'homogénéité du champ.

Le but recherché est l'annulation des premiers termes successifs d'ordre pair et la minimisation des termes résiduels, qui fixeront le degré d'homogénéité du champ.

Les configurations existantes à deux paires de bobines permettent d'annuler les dérivées d'ordre 2, 4, et 6. Ainsi on aura en voisinage de l'origine:

$$B_z(z) = B_0 + B_8\frac{z^8}{8!} + B_{10}\frac{z^{10}}{10!} + \ldots$$

Le défaut $B_d$ d'homogénéité provient, en principe, seulement des termes dont l'ordre est supérieur ou égal à huit. L'annulation est obtenue en ajustant les valeurs des 6 paramètres caractéristiques des bobines. Mais dans de telles configurations, l'accès au centre est possible uniquement longitudinalement.

Pour obtenir un meilleur accès au volume d'examen, il faudrait construire un système semblable beacoup plus grand. Ces solutions deviendraient alors très encombrantes et grosses consommatrices d'énergie électrique et de fluide de refroidissement.

La présente invention, dans le mode préféré de réalisation décrit ici, permet de remédier à ces inconvénients et améliore encore l'homogénéité du champ $\vec{B}_o$.

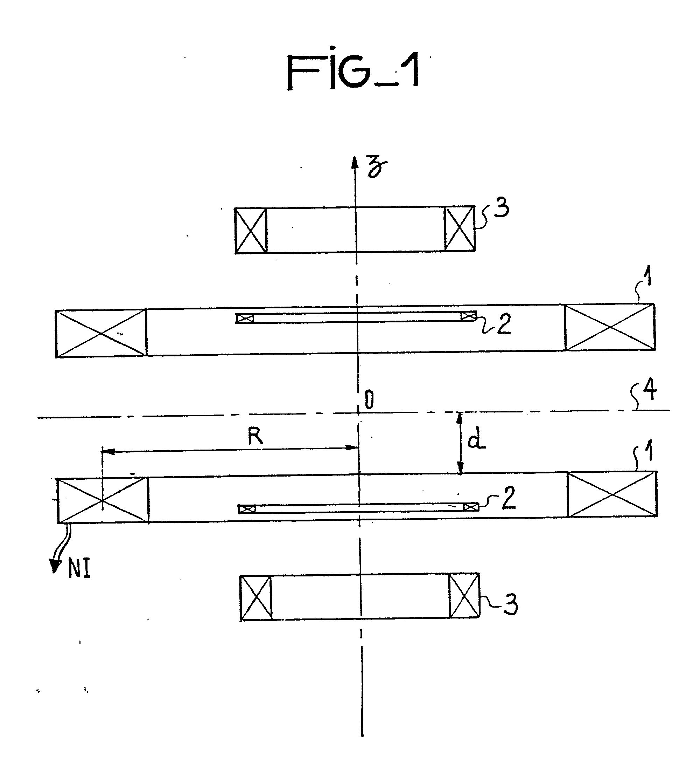

A la figure 1, une configuration à trois paires de bobines a été représentée. Elle comprend les trois paires de bobines 1, 2 et 3. Chacune des bobines 2 est intérieure aux bobines 1. Les deux éléments de référence ont été représentés: le plan de symétrie 4 et l'axe de révolution Oz. Leur intersection, origine du système a été dé signée par le point O. Les trois paramètres caractéristiques de la paire de bobines 1 sont: le courant d'excitation, le rayon R, et la distance d du centre d'une bobine à l'origine O.

Chacune des bobines est calculée en deux paquets de spires:

— un paquet principal,
— un paquet de réglage du champ.

Avec une telle configuration, on dispose de trois paramètres caractéristiques supplémentaires qui permettent d'annuler théoriquement les termes $B_{2n}$ d'ordre inférieur ou égal à 14. Dans l'exemple de réalisation préféré, on annule exactement les termes d'ordre inférieur ou égal à 10 et on minimise les termes résiduels. On obtient au voisinage de l'origine O:

$$B_z(z) = B_0 + B_{12}\frac{z^{12}}{12!} + B_{14}\frac{z^{14}}{14!} + \ldots$$

On peur aussi démontrer théoriquement et vérifier expérimentalement que la réduction des termes résiduels dans le développement en série de Taylor de $B_z$ selon l'axe Oz amène aussi une réduction des termes résiduels dans un développement généralisé à tout un volume d'examen.

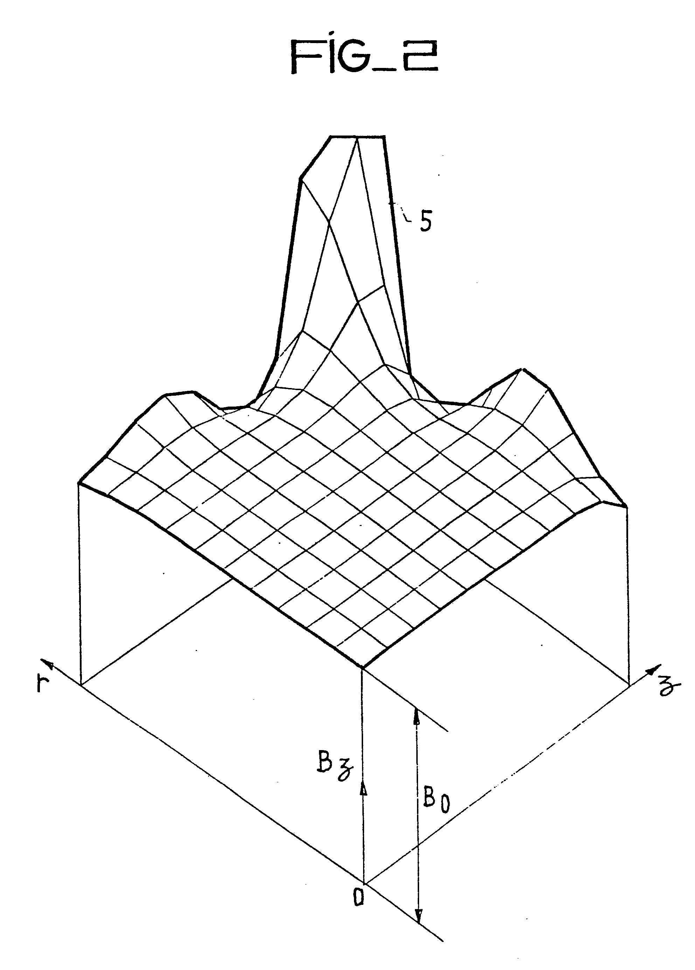

La figure 2 est un stéréogramme qui représente l'amplitude de la composante $B_z(z, r)$ du champ magnétique dans la configuration à trois paires de bobines de l'aimant selon l'invention. Elle représente la valeur du champ dans un quart du volume d'examen. Un pic 5 important est visible à l'extérieur du volume d'examen. Les défauts résiduels d'homogénéité sont confinés aux limites du volume d'examen.

La configuration d'aimant selon l'invention est donc particulièrement avantageuse. Elle permet une plus grande lattitude dans le choix des paramètres caractéristiques des bobines 1, 2 et 3 tout en optimisant les trois grandeurs caractéristiques de l'aimant. On not que la consommation d'énergie et l'encombrement sont sensiblement réduits relativement aux réalisations possible de l'art antérieur.

L'aimant selon l'invention permit:

— un accès longitudinal selon l'axe de révolution Oz,
— un accès transversal dans le plan de symétrie 4.

Il est donc particulièrement adapté pour des examens RMN de corps volumineux.

Il est possible d'utiliser plus de trois paires de bobines. On dispose alors de plus de paramètres pour réduire les défauts d'homogénéité du champ et éventuellement pour augmenter le volume d'examen.

La présente invention permet donc en particulier l'examen transversal. Cette disposition du corps à examiner est avantageuse dans le cadre d'une autre invention des mêmes auteurs déposée dans une autre demande de brevet européen, le même jour que la présente invention, par les mêmes déposants, et publiée sous le N° EP—033 704.

Elle est aussi particulièrement adaptée au contrôle non destructif de structures de formes diverses et d'encombrements différents grâce au volume d'examen grandi, au double accès et à l'encombrement réduit.

**Revendications**

1. Aimant sans circuit magnétique, à haute homogénéité, et comportant un volume d'examen pour exposer un corps à un champ magnétique orientateur ($\vec{B_o}$), constitué d'un agencement de bobines électromagnétiques de révolution, coaxiales, ayant de telles bobines disposées symétriquement par paires de part et d'autre d'un plan de symétrie perpendiculaire à leur axe commun, chaque bobine étant définie par ses paramètres caractéristiques: courant d'excitation (NI), rayon moyen (R) et distance (d) audit plan de symétrie (4), caractérisé en ce que ledit aimant est constitué exclusivement d'au moins trois paires (1, 2, 3) desdites bobines disposées symétriquement par aires de part et d'autre dudit plan de symétrie, ledit volume d'examen, à accès transversal par rapport à l'axe commun(z), étant situé de part et d'autre dudit plan de symétrie (4) et étant delimité par les deux faces opposées des bobines de la paire (1) la plus proche dudit plan de symétrie (4).

2. Aimant selon la revendication 1, caractérisé en ce qu'il comporte trois paires desdites bobines.

3. Aimant selon la revendication 2, caractérisé en ce que l'une des paires desdites bobines (2) et située à l'intérieur de la paire (1) de bobines la plus proche dudit plan de symétrie (4).

4. Aimant selon l'une des revendications précédentes caractérisé en ce que chacune desdites bobines comporte des spires principales et des spires de rélage qui participent au réglage de l'homogénéité du champ.

5. Utilisation de l'aimant selon l'une des revendications précédentes dans un système d'examen utilisant la Résonnance Magnétique Nucléaire pour produire le champ magnétique orientateur ($\vec{B_o}$) dans lequel est disposé le corps à examiner.

**Patentansprüche**

1. Magnet ohne magnetischen Kreis mit hoher Homogenität, der einen Untersuchungsraum aufweist, um einen zu untersuchenden Körper einen Richtmagnetfeld ($\vec{B_o}$) auszusetzen, gebildet durch eine Anordnung von koaxialen Drehkörper-Magnetspulen, wobei solche Spulen paarweise symmetrisch beiderseits einer zu ihrer gemeinsamen Achse senkrechten Symmetrieebene angeordnet sind und jede Spule durch ihre charakteristischen Parameter definiert ist, nämlich: Erregerstrom (NI), mittlerer Radius (R) und Abstand (d) von der Symmetrieebene (4), dadurch gekennzeichnet, dass dieser Magnet lediglich durch wenigstens drei Paare (1, 2, 3) dieser Spulen gebildet ist, die paarweise symmetrisch beiderseits der Symmetrieebene angeordnet sind, wobei der in bezug auf die gemeinsame Achse (Z) seitlich zugängliche Prüfraum sich beiderseits der Symmetrieebene (4) erstreckt und durch die beiden sich gegenüberliegenden Seitenflächen der Spulen des der Symmetrieebene (4) nächstliegenden Spulenpaares (1) begrenzt wird.

2. Magnet nach Anspruch 1, dadurch gekennzeichnet, dass er drei Spulenpaare umfasst.

3. Magnet nach Anspruch 2, dadurch gekennzeichnet, dass eines der Spulenpaare (2) innerhalb des der Symmetrieebene (4) nächstliegenden Spulenpaares (1) angeordnet ist.

4. Magnet nach einem der vorstehenden Ansprüche, dadurch gekennzeichnet, dass jede der Spulen Hauptwindungen und Regulierwindungen aufweist, die zur Regulierung der Homogenität des Feldes beitragen.

5. Anwendung des Magneten nach einem der vorstehenden Ansprüche in einem Untersuchungssystem, das die Magnetische Kernresonanz benutzt, um das Richt-Magnetfeld ($\vec{B_o}$) zu erzeugen, in welches der zu untersuchende Körper eingebracht wird.

**Claims**

1. A magnet without a magnetic circuit, having a high homogeneity and comprising a examination space for exposing a body to be examined to an orienting magnetic field ($\vec{B_o}$), said magnet being constituted by an arrangement of coaxial electromagnetic coils of revolution, said coils being symmetrically disposed by pairs on either side of a symmetry plane perpendicular to their common axis, each coil being defined by its characteristic parameters: exciting current (NI), means radius (R) and distance (d) from said symmetry plane (4), characterized in that said magnet is constituted only by at least three pairs (1, 2, 3) of said coils disposed symmetrically on either side of said symmetry plane, said examination space, which is accessible transversely with respect to said common axis (Z), being located on either side of said symmetry plane (4) and delimited by the two opposed faces of the coils of that pair (1) which is located nearest to said symmetry plane (4).

2. A magnet according to Claim 1, characterized in that it comprises three pairs of said coils.

3. A magnet according to Claim 2, characterized in that one of the pairs of said coils (2) is located within the pair (1) which is nearest to said symmetry plane (4).

4. A magnet according to one of the preceding claims, characterized in that each one of said coils comprises main windings and adjusting windings which contribute to the adjustment of the homogeneity of the field.

5. The utilisation of the magnet according to one of the preceding claims in an examination system using the Nuclear Magnetic Resonance for producing the orienting magnetic field ($B_o$) in which the body to be examined is exposed.

# FIG_1

# FIG_2